# EUROPÄISCHE PATENTSCHRIFT

(11) **EP 1 500 466 B1**
(45) Veröffentlichungstag und Bekanntmachung des Hinweises auf die Patenterteilung: **10.10.2007**
(21) Anmeldenummer: 03016425.5
(22) Anmeldetag: 21.07.2003
(51) Int. Cl.: B24B 27/00, B24D 7/18

(54) **Vorrichtung zum abwechselnden Bearbeiten eines Werkstückes**
Device for alternately machining a workpiece
Dispositif pour usiner une pièce en alternance

(43) Veröffentlichungstag der Anmeldung: 26.01.2005
(73) Patentinhaber: WENDT GmbH, D-40670 Meerbusch (DE)
(72) Erfinder: Lamers, Norbert, 47445 Moers (DE); Scheuvens, Udo, 52525 Heinsberg (DE)
(74) Vertreter: DR. STARK & PARTNER

(56) Entgegenhaltungen:
- EP-A- 1 291 131
- DE-A- 3 902 612

## Beschreibung

Die Erfindung betrifft eine Vorrichtung zum abwechselnden Bearbeiten eines Werkstückes mittels einer für einen Schleifvorgang in Rotation versetzbaren Schleifscheibe oder einer Funkenerosionselektrode, insbesondere zur Bearbeitung von Umfang und Schutzfase an PKD- und PKB-Schneidplatten, wobei die Funkenerosionselektrode als ein der Schleifscheibe in der Form zumindest in etwa angepasstes, für den Erodiervorgang auf die Schleifscheibe wiederabnehmbar aufsetzbares und in eine Pendelbewegung versetzbares Funkenerosionselektrodensegment ausgebildet ist, das Funkenerosionselektrodensegment durch zumindest ein Halteelement , insbesondere eine Magnetbefestigung an der Schleifscheibe anbringbar ist und zur positionierten Anordnung des Funkenerosionselektrodensegmentes an der Schleifscheibe zumindest eine Positioniereinrichtung vorgesehen ist. Eine solche Vorrichtung ist aus der EP 1 291 131 bekannt.

Die Schneidplatten können dabei u. a. Vollmaterial und PKD/PKB-Einsätze auf Hartmetallsubstrat sein.

Der Zweck solcher Vorrichtungen besteht darin, die Vorteile der Bearbeitungsverfahren Erodieren und Schleifen, nämlich hohe Abträge mit hoher Wirtschaftlichkeit bei geringem Verschleiß einerseits und hohe Bearbeitungsqualität und hohe Oberflächengüte bei geringem Schleifaufmaß andererseits zu kombinieren.

Insofern wird in einem ersten Bearbeitungsschritt durch Erodieren das Werkstück in etwa auf die gewünschten Abmessungen gebracht und danach erfolgt durch Schleifen die Feinbearbeitung sowohl in Bezug auf die Form und Abmessungen als auch hinsichtlich der Oberflächengüte.

Es sind derartige Vorrichtungen bekannt, bei denen ein Funkenerosionselektrodensegment mittels zumeist mehrerer Positioniervorrichtungen und zumindest einer Befestigungseinrichtung, z. B. in Form eines magnetischen Befestigungselementes, an der Schleifscheibe angebracht und genau ausgerichtet angeordnet wird. Dabei sind die Positioniervorrichtungen stiftförmig ausgebildet und werden in entsprechende Ausnehmungen in der Schleifscheibe eingeführt.

Nachteilig hierbei ist, dass bei einer solchen Zentrierung eine genaue Ausrichtung sowohl der Winkelstellung der Schleifscheibe als auch der relativen Position von Schleifscheibe und Funkenerosionselektrodensegment zueinander erforderlich ist. Insbesondere muss die Spindel vor Anfahren der Anbringungsposition neu referenziert und danach erst in die von der Referenzierungsposition üblicherweise abweichende Anbringungsposition gefahren werden, da die genaue Achsposition aufgrund des Schleifbetriebes nicht mehr bekannt ist, was z. B. auf einen Schlupf des Keilriemens o. dgl. zurückzuführen ist.

Das Referenzieren stellt jedoch einen beachtlichen und vorzugsweise zu vermeidenden Zeitaufwand dar. Auch muss nach dem Referenzieren die Montageposition sehr genau angefahren werden, da die üblichen Positionierstifte sowie die zugeordnete Bohrung toleriert sind.

Aufgabe der Erfindung ist es, die vorgenannten Nachteile zu vermeiden und eine Vorrichtung zum abwechselnden Bearbeiten eines Werkstückes anzugeben, mit der bei qualitativ hochwertigen Bearbeitungsergebnissen auch ein unkomplizierter und gut automatisierbarer und vor allem ohne hohen Zeitaufwand erfolgender Werkzeugwechsel möglich ist.

Diese Aufgabe wird gelöst durch eine Vorrichtung zum abwechselnden Bearbeiten eines Werkstückes mittels einer für einen Schleifvorgang in Rotation versetzbaren Schleifscheibe oder einer Funkenerosionselektrode, insbesondere zur Bearbeitung von Umfang und Schutzfase an PKD- und PKB-Schneidplatten, wobei die Funkenerosionselektrode als ein der Schleifscheibe in der Form zumindest in etwa angepasstes, für den Erodiervorgang auf die Schleifscheibe wiederabnehmbar aufsetzbares und in eine Pendelbewegung versetzbares Funkenerosionselektrodensegment ausgebildet ist, das Funkenerosionselektrodensegment durch zumindest ein Halteelement , insbesondere eine Magnetbefestigung an der Schleifscheibe anbringbar ist und zur positionierten Anordnung des Funkenerosionselektrodensegmentes an der Schleifscheibe zumindest eine Positioniereinrichtung vorgesehen ist. Hierbei umfasst die Positioniereinrichtung zumindest ein an dem Funkenerosionselektrodensegment oder an der Schleifscheibe vorgesehenes Positionierelement, welches eine positionierte Anbringung des Funkenerosionselektrodensegmentes zumindest in einem bestimmten Drehwinkelbereich der Schleifscheibe, insbesondere bei jedem beliebigem Drehwinkel der Schleifscheibe, ermöglicht, wobei das Positionierelement mit wenigstens einer sich zumindest über einen Teilbereich der Schleifscheibe oder des Funkenerosionselektrodensegmentes erstreckend ausgebildeten Kontaktfläche an der Schleifscheibe oder an dem Funkenerosionselektrodensegment ausrichtend zusammenwirkt.

Hierdurch kann ohne eine aufwendige genaue Positionierung des Drehwinkels der Schleifscheibenspindel das Funkenerosionselektrodensegment bei maximal grober Positionierung der Schleifscheibenspindel erfolgen. Die Spindel muss dann nur um einen bestimmten Winkelbetrag in die Arbeitsposition verfahren werden und kann dort eine gesteuerte Pendelbewegung ausführen. Nach erfolgtem Erodiervorgang wird die Spindel dann wieder in die Anbringposition zurückverfahren und das Funkenerosionselektrodensegment kann für die anschliessende Schleifbearbeitung abgenommen werden.

Erfindungsgemäß kann das Positionierelement zumindest drei eine Ebene aufspannende Punktkontakte umfassen und die Kontaktfläche(n) in den Kontaktbereichen kann (können) so ausgebildet sein, dass die Auflagekräfte der Punktkontakte eine resultierende Flächennormale auf der von den Punktkontakten aufgespannten Ebene bilden.

Dabei können die Punktkontakte durch zumindest teilweise herausragend angeordnete Kugeln gebildet sein. Es sind aber auch alternative Ausgestaltungen möglich.

Vorzugsweise kann eine auf der Schleifscheibe zumindest teilweise umlaufende Nut mit radial zur Rotationsachse der Schleifscheibe ausgerichteter Nuttiefe die Kontaktfläche(n) bilden. Die Positionierelemente für die Punktkontakt können dabei als rechteckförmige Körper mit gerundeter Seitenkante ausgebildet sein, so dass aufgrund des Zusammenwirkens der Krümmung der Nut und des Radius der rechteckförmigen Körper ebenfalls Punktkontakte resultieren. Auch sind V-Profilplatten verwendbar.

Sofern die Nut umlaufend ausgebildet ist, entfällt das Anfahren einer Referenzposition hinsichtlich der Schleifscheibenspindel vollständig.

Vorzugsweise kann die Nut außenseitig an der Schleifscheibe vorgesehen sein, so dass eine leichte Anbringung des Funkenerosionselektrodensegmentes von außen möglich ist.

Dabei kann die Nut leicht geöffnet ausgebildete Nutflanken aufweisen, oder die Nut kann auch parallel oder hinterschnitten ausgebildete Nutflanken aufweisen.

Selbstverständlich ist aber auch eine vertauschte Anordnung von Nut und die Punktkontakte bewirkenden Positionierelementen möglich.

Sofern wenigstens ein Halteelement als Klemmbefestigung ausgebildet ist, kann das Funkenerosionselektrodensegment alternativ oder zusätzlich zur Magnetbefestigung auch mechanisch in seiner Position gehalten sein.

Dabei kann die Klemmbefestigung einen insbesondere gegen eine Rückstellkraft aufgespreizten und in dieser Position fixierten Klemmbereich beinhalten, der eine Befestigung in der Nut bewirkt.

Die Aufspreizung des Klemmbereichs kann hierbei durch den Greifer einer Handhabungseinrichtung insbesondere durch das Vorspannen einer Feder bewirkbar und insbesondere durch das Lösen einer die Feder im vorgespannten Zustand haltenden Verriegelungsklinke oder dergleichen auch wieder rückgängig machbar sein, so dass eine gute Automatisierbarkeit des Montage- bzw. Demontagevorgangs des Funkenerosionselektrodensegmentes gegeben ist.

Vorzugsweise kann das Funkenerosionselektrodensegment kreissegmentförmig ausgebildet sein, so dass eine in Bewegungsrichtung an die Schleifscheibenform angepasste Form des Funkenerosionselektrodensegmentes gegeben ist und mit einem geringen Materialaufwand eine ausreichend dimensionierte Bearbeitungsfläche erzielt wird.

Auch kann das Funkenerosionselektrodensegment eine in etwa zylindermantelsegmentförmig ausgebildete Form aufweisen, so dass das Funkenerosionselektrodensegment an die Formgebung einer in etwa schüsselförmigen Schleifscheibe angepasst ist und somit die entsprechenden Bearbeitungsarten, wie z. B. das Erodieren des Umfangs und das Schleifen der Schutzfase an Schneidplatten o. dgl. möglich sind. Insofern können die Kontaktflächen von Schleifscheibe und Funkenerosionselektrodensegment gegeneinander elektrisch isoliert sein, so dass unabhängig vom technischen Aufbau der Bearbeitungsmaschine elektrische Probleme, insbesondere dadurch, dass die Schleifscheibe "unter Strom steht", von vornherein vermieden werden. Es ist aber auch eine Isolierung direkt an der Elektrode, d. h. zwischen Elektrode und Elektrodenhalter, möglich. Für die Stromübertragung zum Funkenerosionselektrodensegment kann dabei ein Kabel vorgesehen sein.

Bei einem bevorzugten Ausführungsbeispiel kann das Verschleißvolumen des Funkenerosionselektrodensegmentes zum zeitgleichen Austausch des Funkenerosionselektrodensegmentes mit der Schleifscheibe auf das Verschleißvolumen der Schleifscheibe abgestimmt sein, so dass unterschiedliche Austauschintervalle, und somit erhöhte Kosten und höhere Stillstandzeiten vermieden werden.

Eine Steuereinheit kann zur Regelung der Größe des Funkenspaltes zwischen Funkenerosionselektrodensegment und Werkstück vorgesehen und mit der Steuerung der für die Bearbeitung zuständigen Vorrichtung verbunden sein, so dass die Steuerung der Arbeitsparameter des Erodierens zumindest teilweise durch die Steuerung, insbesondere CNC-Steuerung der Vorrichtung erfolgen kann und hierdurch die z. B. entsprechende(n) Vorschubachse(n) angesteuert und verfahren wird (werden).

Weiterhin kann für das Funkenerosionselektrodensegment eine seiner Arbeitsposition naheliegende, außerhalb des Wirkbereiches der Schleifscheibe befindliche und insbesondere gegenüber einer Schärfeinrichtung für die Schleifscheibe angeordnete Lager- und Ruheposition vorgesehen sein, so dass ein automatisiertes Auf- und Absetzen bzw. Anbringen des Funkenerosionselektrodensegmentes an der Schleifscheibe durch eine entsprechende Handhabungseinrichtung erfolgen kann und die Schleifscheibe bei in der Lager- und Ruheposition "geparkten" Funkenerosionselektrodensegment frei rotieren kann.

Im Folgenden werden in der Zeichnung dargestellte Ausführungsbeispiele der Erfindung erläutert. Es zeigen:
- Fig. 1: ausschnittweise ein erstes Ausführungsbeispiel einer erfindungsgemäße Vorrichtung in einer ersten Bearbeitungsposition,
- Fig. 2: den Gegenstand nach Fig. 1 in einer zweiten Bearbeitungsposition und
- Fig. 3: einen Detailausschnitt aus Fig. 1 in vergrößerter Darstellung mit aufgesetztem Funkenerosionselektrodensegment.
- Fig. 4: ausschnittweise ein zweites Ausführungsbeispiel einer erfindungsgemäße Vorrichtung in Draufsicht,
- Fig. 5: den Schnitt A-A des Gegenstandes nach Fig. 4,
- Fig. 6: den Schnitt B-B des Gegenstandes nach Fig. 4,
- Fig. 7: den Schnitt C-C des Gegenstandes nach Fig. 4,
- Fig. 8: einen teilweise Draufsicht auf den Gegenstandes nach Fig. 6 und
- Fig. 9: das Detail Y des Gegenstandes nach Fig. 6.

In allen Figuren werden für gleiche bzw. gleichartige Bauteile übereinstimmende Bezugszeichen verwendet.

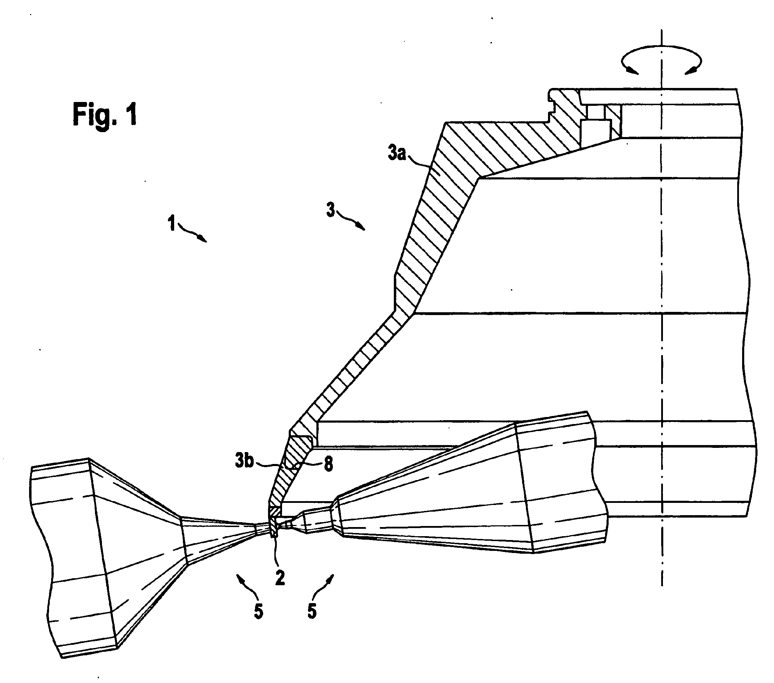

Fig. 1 zeigt ausschnittweise eine Vorrichtung 1 zum abwechselnden Bearbeiten eines als Schneidplatte ausgebildeten Werkstückes 2 mittels eines Schleifwerkzeuges oder einer Funkenerosionselektrode, wobei das Schleifwerkzeug als eine für den Schleifvorgang in Rotation versetzbare Schleifscheibe 3 ausgebildet ist.

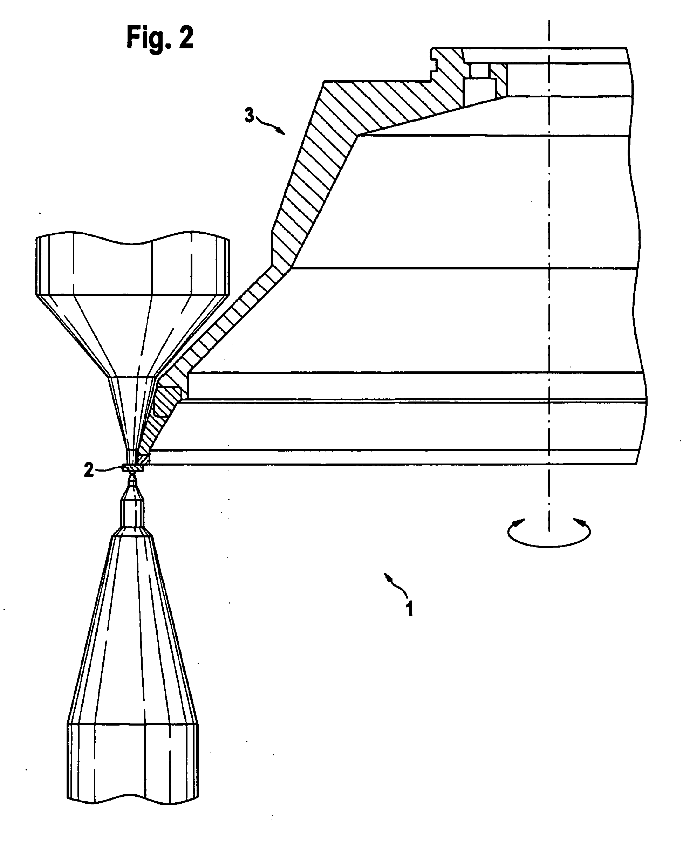

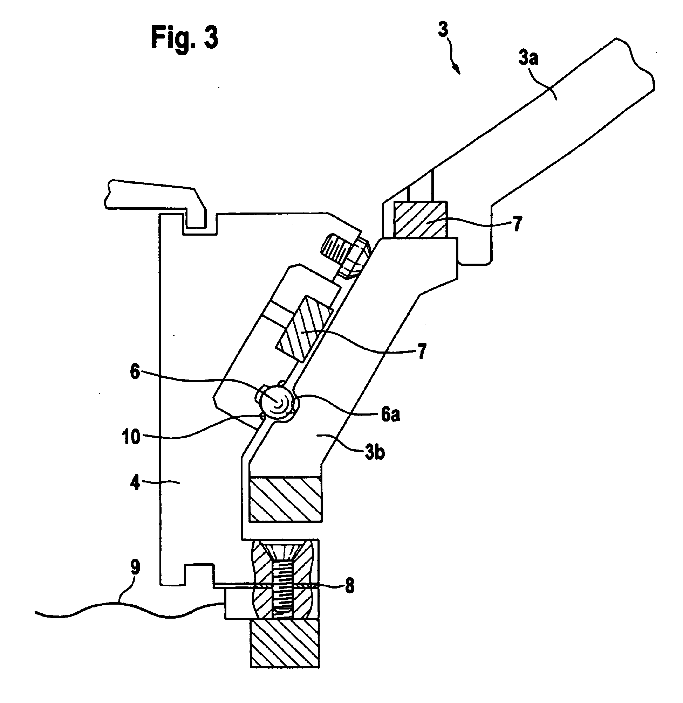

Wie aus Fig. 3 ersichtlich, ist die Funkenerosionselektrode als der Schleifscheibe 3 in der Form angepasstes, für den Erodiervorgang auf die Schleifscheibe 3 aufsetzbares und in eine Pendelbewegung versetzbares Funkenerosionselektrodensegment 4 ausgebildet, wobei die Schleifscheibe 3 eine in etwa schüsselförmige konisch-konkave Form aufweist, die ein Verschwenken aus der in Fig. 1 gezeigten Bearbeitungsposition für den Umfang des Werkstückes 2 in die in Fig. 2 dargestellte Arbeitsposition zur Bearbeitung der Schutzfase des Werkstückes 2 erlaubt. Die Schleifscheibe 3 wird dabei aus einem konkav-konisch ausgebildeten Schleifscheibenflansch 3a und einem daran befestigten Schleifscheibenring 3b gebildet.

Das Werkstück 2 ist während der Bearbeitung in eine Haltevorrichtung 5 klemmend gehalten, die eine Drehung des Werkstückes 2 um seine Mittelachse ermöglicht.

Wie in Fig. 3 gezeigt, ist das Funkenerosionselektrodensegment 4 durch zumindest zwei Kugeln 6, die in eine korrespondierende Nut 6a in der Schleifscheibe 3 eingreifen, ausgerichtet und durch magnetische Befestigungselemente 7 an der Schleifscheibe 3 gehalten. Dabei ist das Funkenerosionselektrodensegment 4 durch eine in der Schleifscheibe 3 vorgesehene Zwischenschicht 8 von der Schleifscheibe 3 elektrisch isoliert und wird über ein Kabel 9 mit elektrischer Energie versorgt. Die dargestellte Schraubverbindungn ist in diesem Fall selbstverständlich nicht leitend oder aber isoliert ausgeführt.

Die Nut 6a kann dabei nur in Teilbereichen der Schleifscheibe 3 vorgesehen sein, insbesondere aber auch umlaufend ausgebildet und vorzugsweise außenseitig an der Schleifscheibe 3 angeordnet sein.

Die Kugeln 6 können dabei in Pendelrichtung gesehen voneinander beabstandet in verschiedene Bereiche einer Nut 6a eingreifen, es ist aber auch möglich, dass eine oder mehrere Kugeln 6 in eine zusätzlich vorgesehene andere Nut 6a (in der Zeichnung nicht dargestellt) eingreifen als mindestens zwei andere Kugeln 6.

Die Kugeln 6 können dabei insbesondere mittels Klebetaschen 10 befestigt sein, es sind jedoch auch andere Befestigungsalternativen möglich.

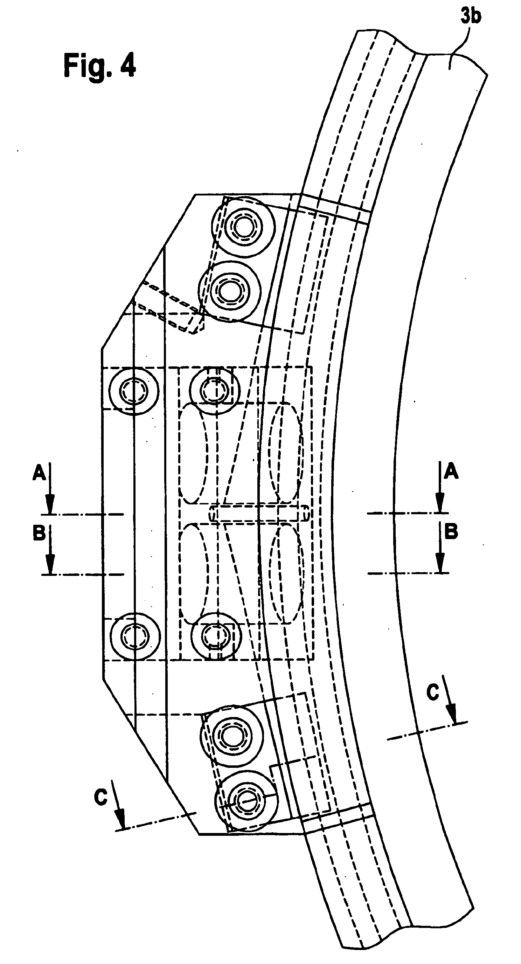

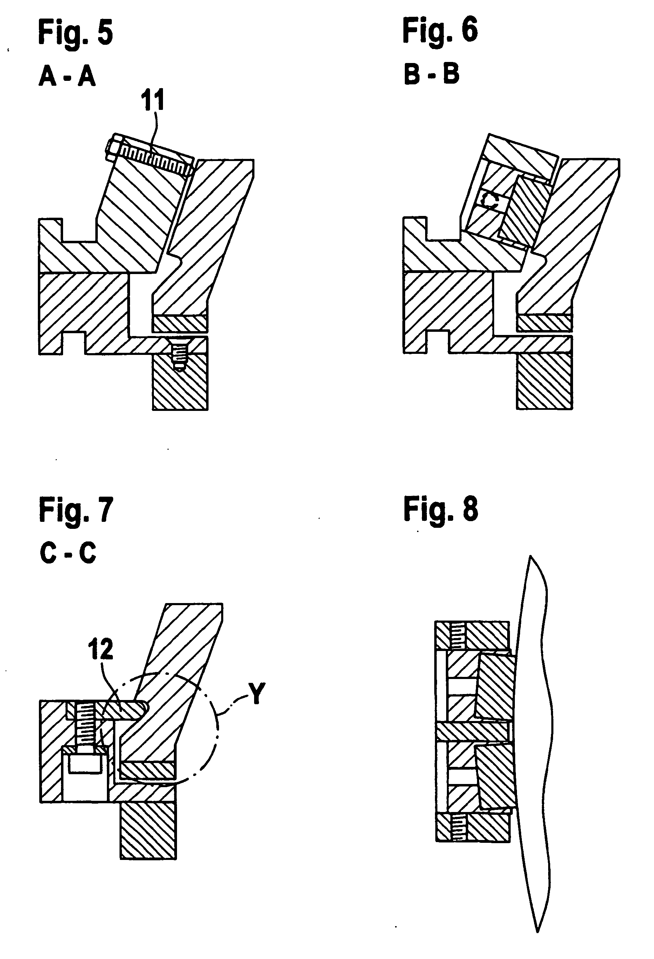

Fig. 4 zeigt ausschnittweise ein zweites Ausführungsbeispiel einer erfindungsgemäße Vorrichtung in Draufsicht. Auf den Schleifscheibenring 3a der Schleifscheibe 3 ist das Funkenerosionselektrodensegment 4 aufgesetzt. Die Befestigung erfolgt hierbei durch die verstellbar ausgebildet und ausgerichtet angeordneten magnetischen Befestigungselemente 7, wie sich auch aus den Fig. 6 und 8 ersehen lässt.

Wie in Fig. 5 dargestellt, wird die ausgerichtete Positionierung einerseits durch einen durch die halbkugelförmige Spitze eines Stiftes 11 auf der Seitenfläche des Schleifscheibenrings 3a der Schleifscheibe 3 und andererseits durch als rechteckförmige Körper 12 mit gerundeter Seitenkante 13 Positionierelemente bewirkt (vgl. Fig. 4, 7 und 9). Die Körper 12 können dabei verstellbar angeordnet und z. B. durch Schraubverbindung in ihrer Position gehalten sein.

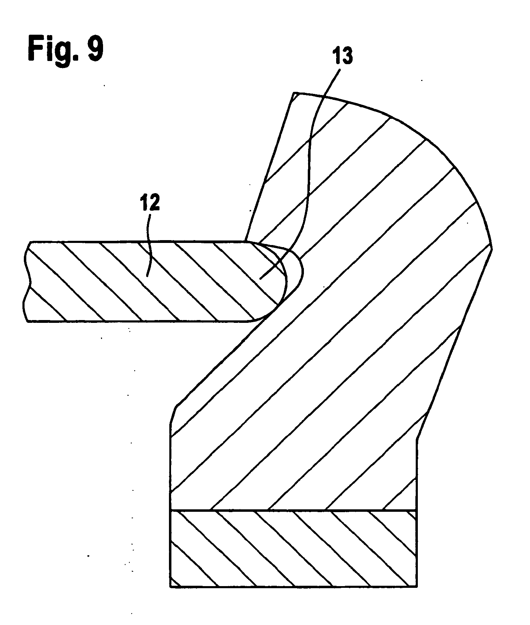

Gemäß den Fig. 7 und 9 greift die gerundete Seitenkante 13 der rechteckförmigen Körper 12 dabei in eine insbesondere umlaufende Nut 6a in dem Schleifscheibenring 3a der Schleifscheibe 3 ein, wobei aufgrund des Zusammenwirkens der Krümmung der Nut 6a und des Radius der gerundeten Seitenkante 13 der rechteckförmigen Körper 12 ebenfalls Punktkontakte resultieren.

## Patentansprüche

1. Vorrichtung (1) zum abwechselnden Bearbeiten eines Werkstückes (2) mittels einer für einen Schleifvorgang in Rotation versetzbaren Schleifscheibe (3) oder einer Funkenerosionselektrode, insbesondere zur Bearbeitung von Umfang und Schutzfase an PKD- und PKB-Schneidplatten, wobei
- die Funkenerosionselektrode als ein der Schleifscheibe (3) in der Form zumindest in etwa angepasstes, für den Erodiervorgang auf die Schleifscheibe (3) wiederabnehmbar aufsetzbares und in eine Pendelbewegung versetzbares Funkenerosionselektrodensegment (4) ausgebildet ist,
- das Funkenerosionselektrodensegment (4) durch zumindest ein Halteelement , insbesondere eine Magnetbefestigung an der Schleifscheibe (3) anbringbar ist und
- zur positionierten Anordnung des Funkenerosionselektrodensegmentes (4) an der Schleifscheibe (3) zumindest eine Positioniereinrichtung vorgesehen ist,
**dadurch gekennzeichnet, dass**
- die Positioniereinrichung zumindest ein an dem Funkenerosionselektrodensegment (4) oder an der Schleifscheibe (3) vorgesehenes Positionierelement umfasst, welches eine positionierte Anbringung des Funkenerosionselektrodensegmentes (4) zumindest in einem bestimmten Drehwinkelbereich der Schleifscheibe (3), insbesondere bei jedem beliebigem Drehwinkel der Schleifscheibe (3), ermöglicht, wobei
- das Positionierelement mit wenigstens einer sich zumindest über einen Teilbereich der Schleifscheibe (3) oder des Funkenerosionselektrodensegmentes (4) erstreckend ausgebildeten Kontaktfläche an der Schleifscheibe (3) oder an dem Funkenerosionselektrodensegment (4) ausrichtend zusammenwirkt.

2. Vorrichtung (1) nach Anspruch 1, **dadurch gekennzeichnet, dass** das Positionierelement zumindest drei eine Ebene aufspannende Punktkontakte umfasst und die Kontaktfläche(n) in den Kontaktbereichen so ausgebildet sind, dass die Auflagekräfte der Punktkontakte eine resultierende Flächennormale auf der von den Punktkontakten aufgespannten Ebene bilden.

3. Vorrichtung (1) nach Anspruch 1 oder 2, **dadurch gekennzeichnet, dass** die Punktkontakte durch zumindest teilweise herausragend angeordnete Kugeln gebildet sind.

4. Vorrichtung (1) nach einem der Ansprüche 1 bis 3, **dadurch gekennzeichnet, dass** eine auf der Schleifscheibe (3) zumindest teilweise umlaufende Nut mit radial zur Rotationsachse der Schleifscheibe (3) ausgerichteter Nuttiefe die Kontaktfläche(n) bildet.

5. Vorrichtung (1) nach Anspruch 4, **dadurch gekennzeichnet, dass** die Nut (6a) leicht geöffnet ausgebildete Nutflanken aufweist.

6. Vorrichtung (1) nach Anspruch 4, **dadurch gekennzeichnet, dass** die Nut (6a) parallel oder hinterschnitten ausgebildete Nutflanken aufweist.

7. Vorrichtung (1) nach einem der Ansprüche 1 bis 6, **dadurch gekennzeichnet, dass** wenigstens ein Halteelement als Klemmbefestigung ausgebildet ist.

8. Vorrichtung (1) nach Anspruch 7, soweit auf einen der Ansprüche 4 bis 6 rückbezogen, **dadurch gekennzeichnet, dass** die Klemmbefestigung einen insbesondere gegen eine Rückstellkraft aufgespreizten und in dieser Position fixierten Klemmbereich beinhaltet, der eine Befestigung in der Nut (6a) bewirkt.

9. Vorrichtung (1) nach Anspruch 8, **dadurch gekennzeichnet, dass** die Aufspreizung des Klemmbereichs durch den Greifer einer Handhabungseinrichtung insbesondere durch das Vorspannen einer Feder bewirkbar ist und insbesondere durch das Lösen einer die Feder im vorgespannten Zustand haltenden Verriegelungsklinke oder dergleichen rückgängig machbar ist.

10. Vorrichtung (1) nach einem der Ansprüche 1 bis 9, **dadurch gekennzeichnet, dass** das Funkenerosionselektrodensegment (4) kreissegmentförmig ausgebildet ist.

11. Vorrichtung (1) nach einem der Ansprüche 1 bis 10, **dadurch gekennzeichnet, dass** das Funkenerosionselektrodensegment (4) eine in etwa zylindermantelförmig ausgebildete Form aufweist.

12. Schleifscheibe (3), gebildet aus mit einem konkavkonisch ausgebildeten Schleifscheibeuflansch (3a) und einem daran befestigten Schleifscheibenring (3b), wobei die Schleifscheibe (3) zur, Verwendung in einer Vorrichtung (1) nach einem der Ansprüche 1 bis 11 ausgebildet ist und wobei somit die Schleifscheibe (3) zum abwechselnden Bearbeiten eines Werkstückes (2) mittels der für einen Schleifvorgang in Rotation versetzbaren Schleifscheibe (3) oder einer Funkenerosionselektrode, die als der Schleifscheibe (3) in der Form zumindest in etwa angepasstes, für den Erodiervorgang auf die Schleifscheibe (3) wiederabnehmbar aufsetzbares Funkenerosionselektrodensegment (4) ausgebildet ist, so ausgestaltet ist, dass das Funkenerosionselektrodensegment (4) durch zumindest ein Halteelement, insbesondere eine Magnetbefestigung, an der Schleifscheibe (3) anbringbar ist, wobei das Funkenerosionselektrodensegment (4) auf den Schleifscheibenring (3b) der Schleifscheibe (3) aufsetzbar ist, und wobei an der Schleifscheibe (3) zur positionierten Anordnung des Funkenerosionselektrodensegmentes (4) zumindest eine Positioniereinrichtung in Form einer umlaufenden Nut (6a) in dem Schleifscheibenring (3b) der Schleifscheibe (3) vorgesehen ist.

## Claims

1. Apparatus (1) for the alternating machining of a workpiece (2) by means of a grinding wheel (3), which can be set in rotation for a grinding process, or by means of an electroerosion electrode, more especially for machining the periphery and protective chamfer of PKD and PKB cutting plates,
- the electroerosion electrode being in the form of an electroerosion electrode segment (4) which is at least substantially adapted to the grinding wheel (3) in respect of configuration, is mountable, for the erosion process, on the grinding wheel (3) so as to be removable therefrom again, and can be set into a pendulum-type movement,
- the electroerosion electrode segment (4) being attachable by at least one retaining member, more especially a magnet-type securement, to the grinding wheel (3), and
- at least one positioning means being provided for the positioned disposition of the electroerosion electrode segment (4) on the grinding wheel (3),
**characterised in that**
- the positioning means includes at least one positioning member, which is provided on the electroerosion electrode segment (4) or on the grinding wheel (3), and which permits a positioned attachment of the electroerosion electrode segment (4) at least in one specific angular range of rotation of the grinding wheel (3), more especially at any desirable angle of rotation of the grinding wheel (3),
- the positioning member co-operating with at least one contact face, which is provided so as to extend at least over a partial region of the grinding wheel (3) or of the electroerosion electrode segment (4), on the grinding wheel (3) or on the electroerosion electrode segment (4) in an aligned manner.

2. Apparatus (1) according to claim 1, **characterised in that** the positioning member includes at least three point contacts, which span a plane, and the contact face(s) is (are) configured in the contact regions so that the forces of application of the point contacts form a resultant surface normal on the plane, which is spanned by the point contacts.

3. Apparatus (1) according to claim 1 or 2, **characterised in that** the point contacts are formed by balls, which are disposed so as to protrude at least partially.

4. Apparatus (1) according to one of claims 1 to 3, **characterised in that** a groove, which surrounds the grinding wheel (3) at least partially and has a groove depth orientated radially relative to the axis of rotation of the grinding wheel (3), forms the contact face(s).

5. Apparatus (1) according to claim 4, **characterised in that** the groove (6a) has groove flanks with a slightly open configuration.

6. Apparatus (1) according to claim 4, **characterised in that** the groove (6a) has groove flanks with a parallel or undercut configuration.

7. Apparatus (1) according to one of claims 1 to 6, **characterised in that** at least one retaining member is in the form of a clamping securement.

8. Apparatus (1) according to claim 7, insofar as it relates to one of claims 4 to 6, **characterised in that** the clamping securement includes a clamping region, more especially splayed-open in opposition to a restoring force and secured in this position, which clamping region effects a securement in the groove (6a).

9. Apparatus (1) according to claim 8, **characterised in that** the splaying-open of the clamping region can be effected by the gripper of an operating means, more especially by the initial tensioning of a spring, and can be cancelled more especially by the release of a locking pawl or the like, which keeps the spring in its initially tensioned state.

10. Apparatus (1) according to one of claims 1 to 9, **characterised in that** the electroerosion electrode segment (4) is in the form of a circular segment.

11. Apparatus (1) according to one of claims 1 to 10, **characterised in that** the electroerosion electrode segment (4) has a configuration which is substantially in the form of a cylinder casing.

12. Grinding wheel (3), formed from a concave-conical grinding wheel flange (3a) and a grinding wheel ring (3b) secured thereto, the grinding wheel (3) being provided for use in an apparatus (1) according to one of claims 1 to 11, and, in consequence, the grinding wheel (3) being designed for the alternating machining of a workpiece (2) by means of the grinding wheel (3), which can be set in rotation for a grinding process, or by means of an electroerosion electrode which is in the form of an electroerosion electrode segment (4), the grinding wheel (3), which is at least substantially adapted to the grinding wheel (3) in respect of configuration, and is mountable, for the erosion process, on the grinding wheel (3) so as to be removable therefrom again, so that the electroerosion electrode segment (4) is attachable to the grinding wheel (3) by at least one retaining member, more especially a magnet-type securement, the electroerosion electrode segment (4) being mountable on the grinding wheel ring (3b) of the grinding wheel (3), and at least one positioning means being provided, in the form of a circumferential groove (6a) in the grinding wheel ring (3b) of the grinding wheel (3), on the grinding wheel (3) for the positioned disposition of the electroerosion electrode segment (4).

## Revendications

1. Dispositif (1) pour usiner en alternance une pièce (2) au moyen d'un disque de meulage (3) mobile en rotation pour une opération de meulage ou d'une électrode d'étincelage, notamment pour l'usinage du pourtour et du chanfrein protecteur de plaquettes de coupe en PKD et en PKB, sachant que
- l'électrode d'étincelage est réalisée sous la forme d'un segment (4) d'électrode d'étincelage de forme au moins approximativement adaptée au disque de meulage (3), pouvant être monté de manière amovible sur le disque de meulage (3) pour le processus d'étincelage et pouvant être déplacé en un mouvement pendulaire,
- le segment (4) d'électrode d'étincelage peut être installé sur le disque de meulage (3) par au moins un élément de retenue, notamment une fixation magnétique, et
- au moins un système de positionnement est prévu sur le disque de meulage (3) afin d'installer de façon positionnée le segment (4) d'électrode d'étincelage,
**caractérisé en ce que**
- le système de positionnement comprend au moins un élément de positionnement prévu sur le segment (4) d'électrode d'étincelage ou sur le disque de meulage (3), élément qui permet d'installer de manière positionnée le segment (4) d'électrode d'étincelage au moins dans une plage donnée d'angle de rotation du disque de meulage (3) et notamment à un angle de rotation quelconque du disque de meulage (3),
- sachant que l'élément de positionnement coopère en alignement avec au moins une surface de contact qui est prévue sur le disque de meulage (3) ou sur le segment (4) d'électrode d'étincelage et qui est réalisée en s'étendant au moins sur une région partielle du disque de meulage (3) ou du segment (4) d'électrode d'étincelage.

2. Dispositif (1) selon la revendication 1, **caractérisé en ce que** l'élément de positionnement comprend au moins trois contacts ponctuels sous-tendant un plan et la ou les surfaces de contact sont configurées dans les régions de contact de telle sorte que la résultante des forces d'appui des contacts ponctuels forme une normale à la surface du plan sous-tendu par les contacts ponctuels.

3. Dispositif (1) selon la revendication 1 ou 2, **caractérisé en ce que** les contacts ponctuels sont formés par des billes disposées au moins partiellement en saillie.

4. Dispositif (1) selon l'une des revendications 1 à 3, **caractérisé en ce qu'**une rainure au moins partiellement entourante sur le disque de meulage (3), dont la profondeur est orientée radialement à l'axe de rotation du disque de meulage (3), forme la ou les surfaces de contact.

5. Dispositif (1) selon la revendication 4, **caractérisé en ce que** la rainure (6a) présente des flancs de rainure réalisés légèrement ouverts.

6. Dispositif (1) selon la revendication 4, **caractérisé en ce que** la rainure (6a) présente des flancs de rainure réalisés parallèles ou contre-dépouillés.

7. Dispositif (1) selon l'une des revendications 1 à 6, **caractérisé en ce qu'**au moins un élément de retenue est réalisé sous forme de fixation par serrage.

8. Dispositif (1) selon la revendication 7, dans la mesure où elle est rattachée à l'une des revendications 4 à 6, **caractérisé en ce que** la fixation par serrage comprend une région de serrage qui est écartée et immobilisée dans cette position notamment à l'encontre d'une force de rappel, et qui produit une fixation dans la rainure (6a).

9. Dispositif (1) selon la revendication 8, **caractérisé en ce que** l'écartement de la région de serrage peut être produit par le preneur d'un équipement de manipulation, en particulier par la précontrainte d'un ressort, et peut être notamment annulé par la libération d'un cliquet de verrouillage ou analogue maintenant le ressort dans l'état précontraint.

10. Dispositif (1) selon l'une des revendications 1 à 9, **caractérisé en ce que** le segment (4) d'électrode d'étincelage est réalisé en forme de segment de cercle.

11. Dispositif (1) selon l'une des revendications 1 à 10, **caractérisé en ce que** le segment (4) d'électrode d'étincelage présente une forme approximative d'enveloppe de cylindre.

12. Disque de meulage (3), constitué d'un collet (3a) de disque de meulage réalisé de forme conique concave et d'une bague (3b) de disque de meulage fixée sur ce collet, sachant que le disque de meulage (3) est conçu pour être utilisé dans un dispositif (1) selon l'une des revendications 1 à 11 et que le disque de meulage (3) est - afin d'usiner en alternance une pièce (2) au moyen du disque de meulage (3) mobile en rotation pour une opération de meulage ou au moyen d'une électrode d'étincelage qui est réalisée sous forme de segment (4) d'électrode d'étincelage de forme au moins approximativement adaptée au disque de meulage (3) et pouvant être monté de manière amovible sur le disque de meulage (3) pour le processus d'étincelage - conçu de telle sorte que le segment (4) d'électrode d'étincelage peut être installé sur le disque de meulage (3) par au moins un élément de retenue, notamment une fixation magnétique, sachant que le segment (4) d'électrode d'étincelage peut être monté sur la bague (3b) du disque de meulage (3) et qu'il est prévu sur le disque de meulage (3), afin d'installer de façon positionnée le segment (4) d'électrode d'étincelage, au moins un système de positionnement sous la forme d'une rainure entourante (6a) dans la bague (3b) du disque de meulage (3).
